(19) Europäisches Patentamt
European Patent Office
Office européen des brevets

(11) **EP 2 731 159 A2**

(12) **EUROPEAN PATENT APPLICATION**

(43) Date of publication:
**14.05.2014 Bulletin 2014/20**

(51) Int Cl.:
**H01L 51/52** *(2006.01)*

(21) Application number: **13191931.8**

(22) Date of filing: **07.11.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **09.11.2012 KR 20120126945**

(71) Applicants:
• **Samsung Electronics Co., Ltd**
**Gyeonggi-do 443-742 (KR)**

• **Samsung Corning Precision Materials Co., Ltd.**
**Chungcheongnam-do 336-841 (KR)**

(72) Inventors:
• **Lee, Gae-hwang**
**449-712 Gyeonggi-do (KR)**
• **Shim, Hong-shik**
**449-712 Gyeonggi-do (KR)**

(74) Representative: **Greene, Simon Kenneth**
**Elkington and Fife LLP**
**8 Pembroke Road**
**Sevenoaks Kent TN13 1XR (GB)**

(54) **Organic Light Emitting Devices**

(57)    An organic light emitting device (OLED) includes a first electrode (40) on a substrate (20), an organic light emitting layer (50) on the first electrode, a second electrode (60) on the organic light emitting layer, and an optical path difference compensation layer (30). The optical path difference compensation layer is between the substrate (20) and the first electrode (40) or on the second electrode (60). The optical path difference compensation layer includes at least one layer in which transmittance decreases as an angle ($\theta_1$, $\theta_2$) between incident light ($L_1$, $L_2$) and an incident surface of the optical path difference compensation layer (IP) increases.

FIG. 1

EP 2 731 159 A2

# FIG. 3

**Description**

BACKGROUND

Field

Example embodiments relate to organic light emitting devices (OLED) having resonant structures with wider viewing angles.

Description of the Related Art

An organic light emitting device (OLED) includes an anode electrode, an organic light emitting layer, and a cathode electrode. As electric current flows through the organic light emitting layer, electrons and holes move to the organic light emitting layer through an electron transport layer and a hole transport layer. The electrons and the holes recombine to emit light.

Unlike a light emitting diode (LED), surface emission is possible in OLEDS, and thus, OLEDS may be used in displays and illuminators. An organic light emitting display, which has adopted the OLED, is a self light-emitting type and does not need a separate light source. Thus, an organic light emitting display may be formed slimmer and lighter when compared to a cathode ray tube (CRT) or a liquid crystal display (LCD), have shorter response time and consume less power. Further, OLEDs have a simpler structure, and thus, may be more easily manufactured. However, OLEDs radiate only about 20% of emitted light to the outside, and thus, have relatively low light efficiency. In order to enhance light efficiency and color purity, a micro-cavity structure is used. However, even if the micro-cavity structure is used, a spectrum may change depending on the viewing angle, and luminance may be reduced (e.g., significantly reduced) as the distance from the front of the screen of the OLED increases.

SUMMARY

One or more example embodiments provide organic light emitting devices (OLEDS) having resonant structures with wider viewing angles.

According to at least one example embodiment, an organic light emitting device (OLED) includes: a first electrode on a substrate; an organic light emitting layer on the first electrode; a second electrode on the organic light emitting layer; and an optical path difference compensation layer including at least two layers, the optical path difference compensation layer being between the substrate and the first electrode or on the second electrode, and the optical path difference compensation layer including at least one layer in which a transmittance decreases as an angle between incident light and an incident surface of the optical path difference compensation layer increases.

According to at least some example embodiments, the optical path difference compensation layer may include: a first layer, a dielectric layer, and a second layer. According to at least one other example embodiment, the optical path difference compensation layer may include: a first dielectric layer, a first layer, a second dielectric layer, and a second layer. The first layer and the second layer may be formed of the same or different metals. The first layer and the second layer may have thicknesses between about 5 and about 30nm. The first layer and the second layer may be formed of at least one of Ag, Au, Al, and an alloy thereof.

According to at least some example embodiments, the first dielectric layer and the second dielectric layer may have different refractive indices. The optical path difference compensation layer may have a thickness greater than 0 and less than about 300nm. The optical path difference compensation layer may include a first metal layer and a second metal layer having different refractive indices. The optical path difference compensation layer may be formed of a semi-transmissive layer.

According to at least some example embodiments, the organic light emitting layer may include an electron transport layer, a light emitting layer, and a hole transport layer. The organic light emitting layer may further include an electron injecting layer and a hole injecting layer.

The optical path difference compensation layer may compensate a resonant optical path difference according to an incident angle of incident light.

One of the first electrode and the second electrode may be a transparent electrode, and the other may be a reflective electrode.

The first electrode and the optical path difference compensation layer may form a micro-cavity, or the second electrode and the optical path difference compensation layer may form a micro-cavity.

In an aspect of the invention there is provided 6.an organic light emitting device (OLED) comprising:

a first electrode on a substrate;

an organic light emitting layer on the first electrode;

a second electrode on the organic light emitting layer; and

an optical path difference compensation layer between the substrate and the first electrode or on the second electrode, the optical path difference compensation layer being configured to compensate a resonant optical path difference according to an angle of incidence of incident light.

BRIEF DESCRIPTION OF THE DRAWINGS

Example embodiments will become more apparent by describing in detail the attached drawings in which:

FIG. 1 is a cross-sectional view schematically illustrating an organic light emitting device (OLED) according an example embodiment;

FIG. 2 is a cross-sectional view illustrating an example of an organic light emitting layer according to an example embodiment;

FIG. 3 is a cross-sectional view illustrating example operation according to an incident angle of light in an optical path difference compensation layer according to an example embodiment;

FIG. 4 is a cross-sectional view illustrating an example of an optical path difference compensation layer according to an example embodiment;

FIG. 5 is a cross-sectional view illustrating another example of an optical path difference compensation layer according to an example embodiment;

FIG. 6 is a cross-sectional view illustrating another example of an optical path difference compensation layer according to an example embodiment;

FIG. 7 is a diagram illustrating an operation of an optical path difference compensation layer according to an example embodiment;

FIG. 8 is a cross-sectional view schematically illustrating an OLED according to another example embodiment;

FIG. 9A is a pictorial view illustrating an example spectrum according to a viewing angle in a comparative example; and

FIG. 9B is a pictorial view illustrating an example spectrum according to a viewing angle of an OLED according to an example embodiment.

DETAILED DESCRIPTION

Example embodiments will now be described more fully with reference to the accompanying drawings, in which some example embodiments are shown. In the drawings, the thicknesses of layers and regions are exaggerated for clarity. Like reference numerals in the drawings denote like elements.

Detailed illustrative embodiments are disclosed herein. However, specific structural and functional details disclosed herein are merely representative for purposes of describing example embodiments. Example embodiments may be embodied in many alternate forms and should not be construed as limited to only those set forth herein.

It should be understood, however, that there is no intent to limit this disclosure to the particular example embodiments disclosed. On the contrary, example embodiments are to cover all modifications, equivalents, and alternatives falling within the scope of the invention. Like numbers refer to like elements throughout the description of the figures.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of this disclosure. As used herein, the term "and/or," includes any and all combinations of one or more of the associated listed items.

It will be understood that when an element is referred to as being "connected," or "coupled," to another element, it can be directly connected or coupled to the other element or intervening elements may be present. In contrast, when an element is referred to as being "directly connected," or "directly coupled," to another element, there are no intervening elements present. Other words used to describe the relationship between elements should be interpreted in a like fashion (e.g., "between," versus "directly between," "adjacent," versus "directly adjacent," etc.).

The terminology used herein is for the purpose of describing particular embodiments only and is not intended to be limiting. As used herein, the singular forms "a," "an," and "the," are intended to include the plural forms as well, unless the context clearly indicates otherwise. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

It should also be noted that in some alternative implementations, the functions/acts noted may occur out of the order noted in the figures. For example, two figures shown in succession may in fact be executed substantially concurrently or may sometimes be executed in the reverse order, depending upon the functionality/acts involved.

Various example embodiments of the present invention will now be described more fully with reference to the accompanying drawings in which some example embodiments of the invention are shown. In the drawings, the thicknesses of layers and regions are exaggerated for clarity. The embodiments described below are merely examples, and various modifications for such embodiments are possible. Hereinafter, the terms "on ~," "on the top of~", or the like are used to describe a non-contacting object as well as a contacting object.

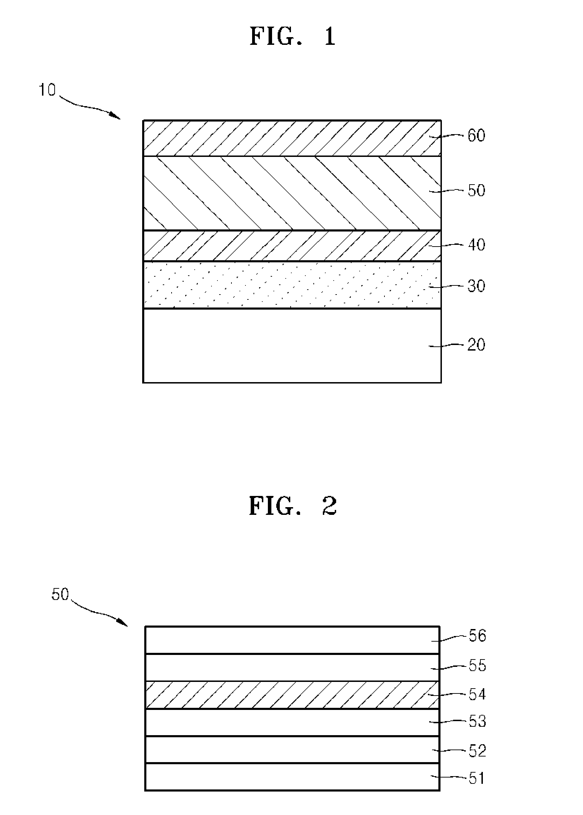

FIG. 1 is a cross-sectional view schematically illustrating an organic light emitting device (OLED) 10 according an example embodiment. In the example embodiment in FIG. 1, the OLED 10 includes a substrate 20, a first electrode 40 on the substrate 20, a second electrode 60, and an organic light emitting layer 50 between the first electrode 40 and the second electrode 60. The OLED 10 further includes an optical path difference compensation layer 30 between the first electrode 40 and the substrate 20.

For example, the substrate 20 may be a glass substrate allowing light transmission. The first electrode 40 may be transparent anode electrode to transmit light. In one example, the first electrode may be made of transparent, conductive materials such as Indium Tin Oxide (ITO), Indium Zinc Oxide (IZO) or the like.

The organic light emitting layer 50 may be formed of an organic compound including, for example, a polymer organic compound. The organic light emitting layer 50 may be formed of a single layer or multiple layers. FIG. 1 illustrates an example in which the organic light emitting layer is formed of a single layer.

FIG. 2 illustrates an example of an organic light emitting layer 50 formed of multiple layers. In this example, the organic light emitting layer 50 includes a hole injecting layer 51, a light emitting layer 54, and an electron injecting layer 56 as illustrated in FIG. 2. A hole transport layer 52 and an interlayer 53 are further provided between the hole injecting layer 51 and the light emitting layer 54. An electron transport layer 55 is provided between the light emitting layer 54 and the electron injecting layer 56.

The second electrode 60 may be a cathode electrode formed of, for example, a conductive material having a relatively high reflectance. In one example, the second electrode 60 may be formed of a reflective metal such as aluminum (Al), silver (Ag), magnesium (Mg), barium (Ba), combinations thereof or the like.

The optical path difference compensation layer 30 may be a semi-transmissive layer formed of, for example, a material having an attribute in which a portion of light is transmitted and a portion of the light is reflected.

In one example, the optical path difference compensation layer 30 may have a multi-layer structure including at least two layers. Further, at least one of the two layers may be configured such that as an angle between incident light and an incident plane of the optical path difference compensation layer increases, the transmittance decreases. Some examples of materials having such attributes are metals, photonic crystals, and refractive index anisotropic materials.

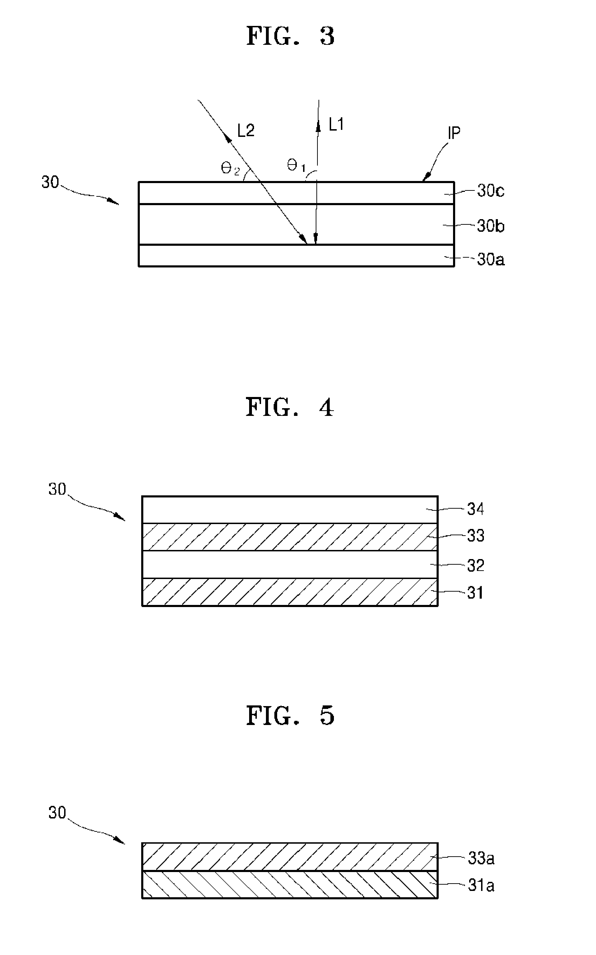

Referring to FIG. 3, the optical path difference compensation layer 30 may include at least one layer in which the transmittance decreases as the angle between incident light and an incidence plane of the optical path difference compensation layer increases. Further, a dielectric layer may be optionally provided between at least two layers.

In the example shown in FIG. 3, the optical path difference compensation layer 30 includes a first layer 30a, a dielectric layer 30b, and a second layer 30c. The first layer 30a and the second layer 30c may be formed of, for example, metal. In one example, the first layer 30a and the second layer 30c may be formed of a material selected from the group including Ag, Au and Al, or an alloy thereof.

Referring to FIG. 3, when a first angle $\theta_1$ between a first incident light L1 and the incidence plane IP of the optical path difference compensation layer 30 is greater than a second angle $\theta_2$ between a second incident light L2 and the incidence plane IP of the optical path difference compensation layer 30, the transmittance T1 of the first incident light L1 is smaller than the transmittance T2 of the second incident light L2. As such, the optical path difference compensation layer 30 may show a more uniform spectrum regardless of an angle of incidence of the light by compensation of the resonant optical path difference by the optical path difference compensation layer 30. As a result, the view angle may be widened.

FIG. 4 illustrates another example of an optical path difference compensation layer. In this example embodiment, the optical path difference compensation layer 30 includes a first layer 31, a first dielectric layer 32, a second layer 33 and a second dielectric layer 34. The first layer 31 and the second layer 33 may be formed of the same material, or different materials. The first layer 31 and the second layer 33 may have, for example, respective thicknesses of about 5 to about 40 nm. The optical path difference compensation layer 30 may have, for example, a thickness greater than 0, but less than about 300nm.

For example, the first layer 31 and the second layer 33 may be formed of metal, that is, a material selected from the group including Ag, Au and Al, or an alloy thereof. The first dielectric layer 32 and the second dielectric layer 34 may be formed of the same or substantially the same material. Further, the first dielectric layer 32 and the second dielectric layer 34 may be formed of materials having different refractive indices. For example, one or more of the dielectric layers 32 and 34 may be formed of ZnS, $TiO_2$, $SiO_2$, a combination thereof or the like.

FIG. 5 illustrates another example embodiment of an optical path difference compensation layer 30 shown in FIG. 1. In this example, the optical path difference compensation layer 30 includes a first layer 31a and a second layer 33a. The first layer 31a and the second layer 33a may be formed of different materials, for example, metals having different refractive indices. The first layer 31a and the second layer 33a may be formed of a material selected from the group including Ag, Au and Al, or an alloy thereof.

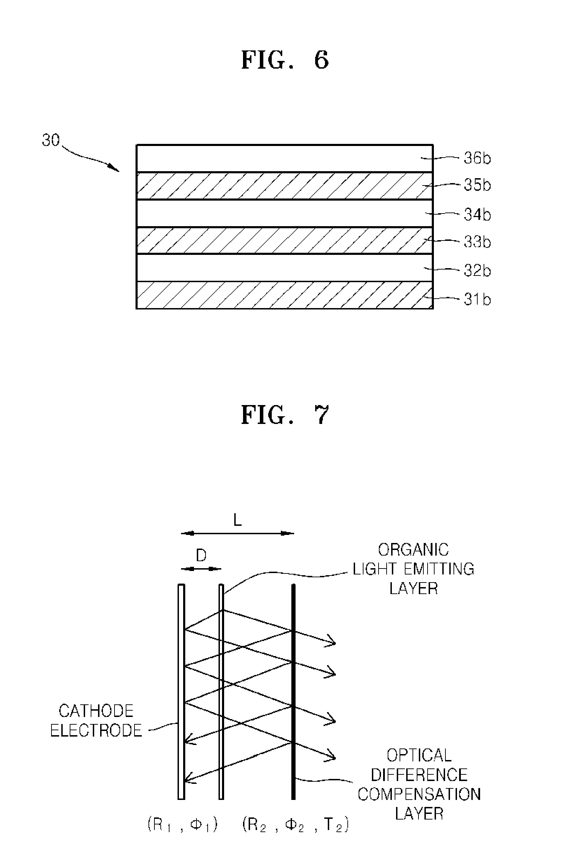

FIG. 6 illustrates another example embodiment of the optical path difference compensation layer 30 shown in FIG. 1. In this example, the optical path difference compensation layer 30 includes a first layer 31b, a first dielectric layer 32b, a second layer 33b, a second dielectric layer 34b, a third layer 35b and a third dielectric layer 36b. The first layer 31b, the second layer 33b, and the third layer 35b may be formed of the same, substantially the same, or different materials. Further, two layers may be formed of the same, or substantially the same material, and two layers may be formed of different materials. According to at least some example embodiments, the first dielectric layer 32b, the second dielectric layer 34b, and the third dielectric layer 36b may be formed of the same or substantially the same material, or may be formed of different materials. Further, two dielectric layers may be formed of the same or substantially the same material, and two dielectric layers may be formed of different materials.

As described above, the optical path difference compensation layer may include at least two layers. Further, the dielectric layer may be between the at least two layers.

Hereinafter, example principles of generating light in an organic light emitting device (OLED) will be described. If a voltage is applied to the first electrode 40 and the second electrode 60, then electrons and holes are discharged. As the electrons and the holes recombine within the organic light emitting layer, light is generated. The light emitted from the organic light emitting layer 50 may be emitted to the outside (externally) through the first electrode 40. The organic light emitting device (OLED) may be classified as a top-emitting structure or a bottom-emitting structure depending on the direction in which light is emitted. FIG. 1 illustrates an example of an OLED having a backlit structure. However, example embodiments are not limited to this example, and may also be applied to an OLED having a top-emitting structure.

The light emitted from the organic light emitting layer 50 is emitted toward the first electrode 40 and the second electrode 60, and the light, which is directed toward the first electrode 40, passes through the first electrode 40 formed of a transparent material so as to be incident on the light path difference compensation layer 30. The light incident on the light path difference compensation layer 30 is partly emitted to the outside, and the remaining light is reflected toward the second electrode 60. The second electrode 60 is formed of a material having a relatively high reflectance, and thus, the light emitted toward the second electrode 60 is reflected back toward the light path difference compensation layer 30.

According to at least this example embodiment, light may show resonant effects between the optical path difference compensation layer 30 and the second electrode 60, the optical path difference compensation layer 30 and the second electrode 60 may form a micro-cavity, and reinforcing interference occurs in a certain wavelength, thereby increasing light intensity.

The light intensity may be expressed as a function of a wavelength of light and an incident angle of light as shown below in Equation 1.

<Equation 1>

$$I_{OLED}(\lambda,\theta) = I_{emission}(\lambda)^2 \; T_2 \; \frac{1 + R_1 + 2(R_1)^{1/2}\cos(4\pi nD\cos\theta_{org}/\lambda - \Phi_1)}{1 + R_1 R_2 - 2(R_1 R_2)^{1/2}\cos(4\pi nL\cos\theta_{org}/\lambda - \Phi_1 - \Phi_2)}$$

FIG. 7 is a simplified mimetic diagram illustrating an OLED of FIG. 1 in order to explain a relationship between light intensity, a light wavelength and a light incident angle. In Equation 1, "$I_{OLED}$" denotes light intensity emitted from an OLED, and is a function of a wavelength and an angle. "$I_{emission}$" denotes a spectrum of light emitted from the OLED. "T" denotes a transmittance, and "R" denotes a reflectance of light reflected from the OLED to the outside. "D" denotes a distance between an organic light emitting layer and a cathode electrode. "L" denotes a distance between the cathode electrode and the optical path difference compensation layer, that is, a resonant length. Further, "n" denotes a reflective index, "$\theta$" denotes a view angle on the OLED in a vertical direction in the air, and "$\theta_{org}$" denotes an angle in an organic light emitting layer corresponding to angle $\theta$. "$\theta$" and "$\theta_{org}$" may be determined according to Snell's law. "$\Phi_1$" denotes a phase value when light is reflected from a cathode electrode, "$\Phi_2$" denotes a phase value when light is reflected from a semi-transmission layer. Further, n, $\Phi_1$ and $\Phi_2$ are functions of wavelength.

Referring to Equation 1, when the view angle $\theta$ increases, $\theta_{org}$ also increases and the cosine function value decreases. If the cosine function value decreases, this is as if the distance L (resonant length) has decreased. Accordingly, the spectrum shifts to the short wavelength side as the view angle increases in the OLED using a resonant structure.

In the optical path difference compensation layer of an OLED according to at least some example embodiments, by compensating the resonant optical path difference according to the view angle, the color spectrum may be set to be maintained constant or substantially constant regardless or independent of the view angle. When light is reflected from the optical path difference compensation layer, the phase value $\Phi_2$ is correlated with the angle $\theta_{org}$ and the $\cos(4\pi nL\cos\theta_{org}/\lambda - \Phi_1 - \Phi_2)$ value is kept constant or substantially constant regardless or independent of the $\theta_{org}$ value so that the light intensity may be kept constant or substantially constant regardless of the $\theta_{org}$ value. In other words, constant or substantially constant light intensity may be maintained regardless of the $\theta_{org}$ value even when the phase value $\Phi_2$ of reflected light in the optical path difference compensation layer is changed according to the $\theta_{org}$ value.

When $\theta_{org}$ increases, $\cos(\theta_{org}/\lambda)$ decreases and accordingly the $\Phi_1$ value decreases. Thus, the $\cos(4\pi nL\cos\theta_{org}/\lambda - \Phi_1 - \Phi_2)$ value may be maintained without significant change. Similarly, when $\theta_{org}$ decreases, $\cos(\theta_{org}/\lambda)$ increases and accordingly the $\Phi_1$ value increases, and thereby the $\cos(4\pi nL\cos\theta_{org}/\lambda - \Phi_1 - \Phi_2)$ value may be maintained without significant change.

When the phase value $\Phi_2$ of reflected light in the optical path difference compensation layer is controlled according to one or more example embodiments, light intensity may be kept constant or substantially constant regardless or independent of viewing angle. Likewise, the phase value of the light reflected in the optical path difference compensation layer may compensate the resonant optical path difference according to the viewing angle, and thereby a wider viewing angle may be secured. If the $\Phi_1$ value increases when $\theta_{org}$ decreases, and the $\Phi_1$ value decreases when $\theta_{org}$ increases, the variation of the optical spectrum according to the viewing angle may be reduced. If the optical path difference compensation layer has a feature that transmittance decreases when an angle between incident light and the incident plane of the optical path difference compensation layer increases, then the resonant optical path difference may be compensated. In Equation 1, the optical resonant path difference may be compensated by maintaining a constant or substantially constant $\cos(4\pi nL\cos\theta_{org}/\lambda - \Phi_1 - \Phi_2)$ value regardless of the value of $\theta_{org}$. As the $\theta_{org}$ value decreases, the cosine value decreases. If the optical path difference compensation layer is used, then the L value increases proportionally as the cosine value decreases. Thus, the $\cos(4\pi nL\cos\theta_{org}/\lambda - \Phi_1 - \Phi_2)$ value may be maintained constant or substantially constant. If the $\theta_{org}$ value decreases (when compared with vertical incidence), then resonant length L value decreases due to the semi-transmission layer in which transmittance increases as the incident angle increases (when compared with vertical incidence) in the optical path difference compensation layer. However, if $\theta_{org}$ value increases, then the resonant length L value increases because light is reflected after the light passes through the optical path difference compensation layer and reaches the bottom. For example, in FIG. 3, the first incident light L1 resonates in the second layer 30c, but the second incident layer L2 may resonate in the first layer 30a.

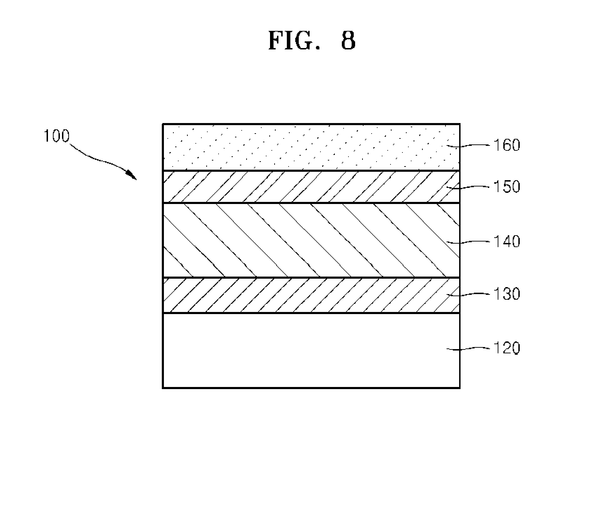

FIG. 8 schematically illustrates an organic light emitting device (OLED) 100 according to another example embodiment. In this example, the OLED 100 includes a substrate 120, a first electrode 130 on the substrate, a second electrode 150, and an organic light emitting layer 140 between the first electrode 130 and the second electrode 150. An optical path difference compensation layer 160 is provided on the second electrode 150.

The substrate 120 may be, for example, a glass substrate to transmit light. The first electrode 130 may be a cathode electrode formed of a material having a relatively high reflectance. The second electrode 150 may be a transparent anode electrode configured to transmit light. In one example, the second electrode 150 may be formed of a transparent, conductive material such as Indium Tin Oxide (ITO), Indium Zinc Oxide (IZO), combinations thereof or the like.

The organic light emitting layer 140 may be formed of an organic compound including, for example, a polymer organic compound. The organic light emitting layer 140 may be formed of a single layer or multiple layers. The organic light emitting layer 140 may be the same or substantially the same as the organic light emitting layer 50, which has been described with reference to FIGS. 1 and 2, and thus a detailed description will be omitted here.

The OLED 100 of FIG. 8 is a bottom-emitting type in which light emitted in the organic light emitting layer 140 is output to the upper side. The OLED 100 has a micro-cavity structure in which light resonates between the first electrode 130 and the optical path difference compensation layer 160. The function and effects of the organic path difference compensation layer 160 are the same or substantially the same as those of the optical path difference compensation layer 30, which have been described with reference to FIGS. 1 to 7. As described above, a wider viewing angle may be secured as the resonant optical path difference is compensated (e.g., constantly compensated) by the optical path difference compensation layer 160 regardless or independent of the viewing angle.

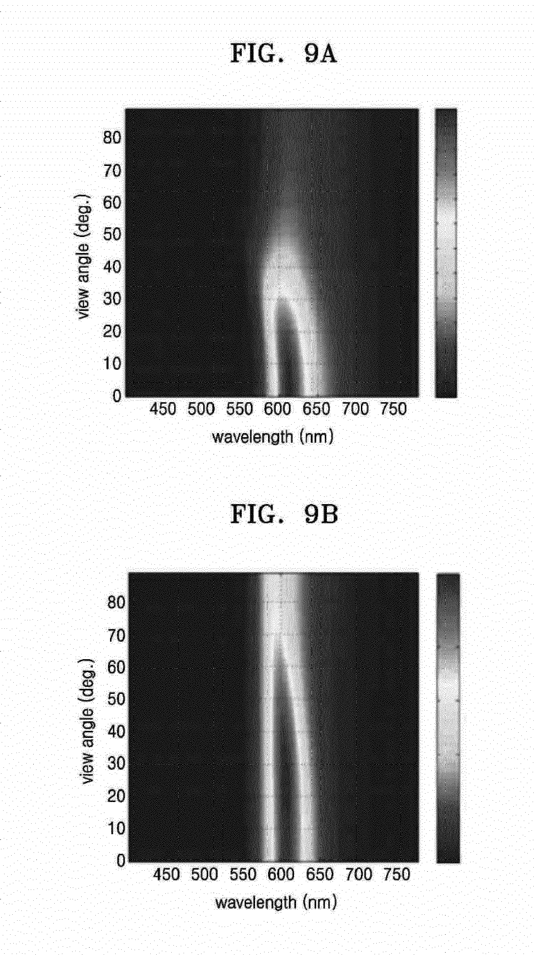

FIG. 9A illustrates an example spectrum according to a viewing angle in a comparative example. The comparative example has a structure including a substrate, a first electrode, an organic light emitting layer, a second electrode and a semi-transmissive layer. The first electrode is formed of ITO, the second electrode is formed of Al, and the semi-transmissive layer is formed of Mg-doped Ag. The organic light emitting layer includes a hole injecting layer, a hole transport layer, a light emitting layer, an electron transport layer, and an electron injecting layer. The comparative example shows that the spectrum is not constant according to the viewing angle.

FIG. 9B illustrates an example spectrum according to a viewing angle of an organic light emitting device (OLED) including the optical path difference compensation layer of FIG. 4. FIG. 9B shows that the spectrum is kept constant or substantially constant according to the viewing angle. OLEDs according at least some example embodiments also maintain the same or substantially the same color regardless of the viewing angle, and the luminance may have a Lambertian distribution. As such, OLEDs according to at least some example embodiments may have wider viewing angles relative to conventional OLEDs. OLEDs according to one or more example embodiments may be used in illuminators using OLEDs as well as OLED displays.

While example embodiments have been particularly shown and described, it will be understood by those of ordinary skill in the art that various changes in form and details may be made therein.

**Claims**

1. An organic light emitting device (OLED) comprising:

   a first electrode on a substrate;
   an organic light emitting layer on the first electrode;
   a second electrode on the organic light emitting layer; and
   an optical path difference compensation layer including at least two layers, the optical path difference compensation layer being between the substrate and the first electrode or on the second electrode, the optical path difference compensation layer including at least one layer in which transmittance decreases as an angle between incident light and an incident surface of the optical path difference compensation layer increases.

2. The OLED of claim 1, wherein the optical path difference compensation layer includes a first layer, a dielectric layer and a second layer.

3. The OLED of claim 2, wherein the first layer and the second layer are formed of different metals or the same metal.

4. The OLED of claim 2 or 3, wherein the first layer and the second layer respectively have a thickness of about 5 to about 30nm.

5. The OLED of claim 2, 3 or 4 wherein the first layer and the second layer are formed of at least one of Ag, Au and Al, or an alloy thereof.

6. The OLED of claim 1, wherein the optical path difference compensation layer includes a first dielectric layer, a first layer, a second dielectric layer and a second layer.

7. The OLED of claim 6, wherein the first dielectric layer and the second dielectric layer have different refractive indices.

8. The OLED of any preceding claim, wherein the optical path difference compensation layer has a thickness larger than 0 and not greater than about 300nm.

9. The OLED of any preceding claim, wherein the optical path difference compensation layer includes a first metal layer and a second metal layer having different refractive indices.

10. The OLED of any preceding claim, wherein the optical path difference compensation layer is formed of a semi-transmissive layer.

11. The OLED of any preceding claim, wherein the organic light emitting layer includes an electron transport layer, a light emitting layer, and a hole transport layer.

12. The OLED of claim 11, wherein the organic light emitting layer further includes an electron injecting layer and a hole injecting layer.

13. The OLED of any preceding claim, wherein the optical path difference compensation layer is configured to compensate a resonant optical path difference according to an incident angle of incident light.

14. The OLED of any preceding claim, wherein one of the first electrode and the second electrode is a transparent electrode, and the other is a reflective electrode.

15. The OLED of any preceding claim, wherein the first electrode and the optical path difference compensation layer form a micro cavity, or the second electrode and the optical path difference compensation layer form a micro cavity.

# FIG. 1

10

60
50
40
30
20

# FIG. 2

50

56
55
54
53
52
51

# FIG. 3

# FIG. 4

# FIG. 5

# FIG. 6

30

36b
35b
34b
33b
32b
31b

# FIG. 7

L

D

ORGANIC
LIGHT EMITTING
LAYER

CATHODE
ELECTRODE

OPTICAL
DIFFERENCE
COMPENSATION
LAYER

$(R_1, \Phi_1)$   $(R_2, \Phi_2, T_2)$

# FIG. 8

## FIG. 9A

## FIG. 9B